# EUROPÄISCHE PATENTSCHRIFT

(11) **EP 0 410 426 B1**
(45) Veröffentlichungstag und Bekanntmachung des Hinweises auf die Patenterteilung: **06.10.1993**
(21) Anmeldenummer: 90114277.8
(22) Anmeldetag: 25.07.1990
(51) Int. Cl.: H01R 13/58, H01R 9/07

(54) **Vorrichtung zur Zugentlastung**
Device for strain relief
Dispositif de décharge de traction

(30) Priorität: 28.07.1989 DE 8909191 U
(43) Veröffentlichungstag der Anmeldung: 30.01.1991
(73) Patentinhaber: Siemens Nixdorf Informationssysteme Aktiengesellschaft, 33102 Paderborn (DE)
(72) Erfinder: Klimke, Peter, Dipl.-Ing., D-8000 München 90 (DE)
(74) Vertreter: Fuchs, Franz-Josef, Dr.-Ing.

(56) Entgegenhaltungen:
- EP-A- 0 162 124
- US-A- 4 295 696

## Beschreibung

Die Erfindung betrifft eine Vorrichtung zur Zugentlastung für auf Leiterbahnanschlüsse von starren Leiterplatten unmittelbar aufgelöteten flexiblen Leiterplatten.

Aus EP-A-0162124 ist eine Vorrichtung und ein Verfahren zum elektrischen und mechanischen Verbinden flexibler gedruckter Schaltfolien bekannt.

Flexible Leiterplatten werden häufig zur Verdrahtungszwecken verwendet. So ist es in der SMD-Technik häufig notwendig, flexible Leiterplatten unmittelbar auf die Anschlüsse von starren Leiterplatten aufzulöten, um eine Verbindung zwischen der starren Leiterplatte und beispielsweise entsprechenden Steckelementen eines Steckers auf der starren Leiterplatte herzustellen. Die Lötstellen sind wegen konstruktiv notwendiger Biegungen und bei mechanischer Belastung auf Scherung und Zug beansprucht. Da die Lötflächen sehr klein sind, besteht bei diesen Belastungen die Gefahr, daß sich die Kupferkaschierung vom Basismaterial löst. Zusätzlich muß zum Löten die Kupferkaschierung der flexiblen Schaltung an der Lötstelle freigelegt sein, d.h. frei von Deckfolie und Kleber. Die Übergangsstelle vom Lötbereich zum Verdrahtungsbereich ist bei der flexiblen Leiterplatte bruchgefährdet.

Aufgabe der Erfindung ist es daher, eine Vorrichtung zu schaffen, durch die die mechansiche Beanspruchung der flexiblen Leiterplatte im Lötbereich verringert wird.

Zur Lösung dieser Aufgabe wird die Vorrichtung gemäß der Erfindung derart ausgebildet, daß an der für den Anschluß an die starre Leiterplatte vorgesehenen Seite der flexiblen Leiterplatte ein Bügel aus starrem Material, wie z.B. faserverstärktem Epoxydharz, auflaminiert ist, der im Bereich der Lötstellen ausgespart und außerdem mit Laschen versehen ist, in denen sich Bohrungen für Befestigungsschrauben befinden.

Durch diese Maßnahmen erhält man eine einfache Zugentlastung durch die die vorstehend genannten Gefährdungen der flexiblen Leiterplatte im Lötbereich vermieden werden.

Bei ausreichender Genauigkeit der Bohrungen oder Laschen im starren Teil der flexiblen Leiterplatte und in der starren Leiterplatte bezogen auf das jeweilige Leiterbild kann mit dem auflaminierten Bügel bei der Montage auch gleichzeitig eine Justierung zum Löten erreicht werden.

Anhand der Ausführungsbeispiele nach den FIG 1 bis FIG 4 wird die Erfindung erläutert. Es zeigen
- FIG 1: ein Anwendungsbeispiel, bei dem die flexible Leiterplatte als Verbindungsstück zwischen einer starren Leiterplatte und einem Stecker verwendet wird,
- FIG 2: einen Ausschnitt aus dem Verbindingsbereich zwischen Stecker und Leiterplatte in Draufsicht,
- FIG 3: die flexible Leiterplatte in Draufsicht,
- FIG 4: einen Schnitt durch die flexible Leiterplatte nach FIG 3.

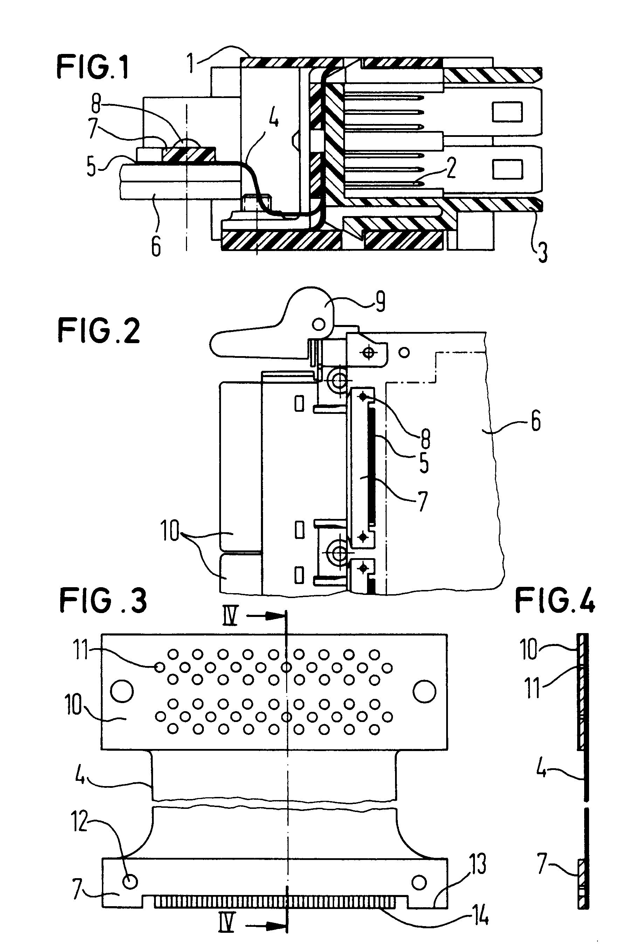

Die FIG 1 zeigt die flexible Leiterplatte 4 als Verbindungselement zwischen der starren Leiterplatte 6 und einem Stecker 1. Die zu kontaktierenden Stifte 2 sind dabei von einem Steckergehäuse mit einem Schutzkragen 3 umgeben. Die Kontaktierung auf der starren Leiterplatte 6 erfolgt durch unmittelbares Auflöten der flexiblen Leiterplatte 4 an der Lötstelle 5, wodurch die Verbindung zu den Anschlüssen der starren Leiterplatte 6 hergestellt wird. Ein auf der Leiterplatte auflaminierter Bügel 7, der beispielsweise aus einem glasfaserverstärkten Epoxydharz bestehen kann, hält das Ende der flexiblen Leiterplatte 4 auf der starren Leiterplatte 6 fest, so daß an der Lötstelle 5 keine Zug- oder Torsionskräfte auftreten können.

In FIG 2 ist ein Ausschnitt aus einer starren Leiterplatte, sowie der auf ihr mit Hilfe der Bügel 7 befestigten flexiblen Leiterplatten, dargestellt. Die Bügel 7 werden dabei durch vorgesehene Bohrungen mit Hilfe von Befestigungselementen, im speziellen Fall eines Kerbnagels 8, auf der starren Leiterplatte befestigt. Die Anschlußplatte 10 der flexiblen Leiterplatte 4 ist schematisch ersichtlich, ebenso die Verriegelungsvorrichtung 9 für die Befestigung dieser Leiterplatte in einer Aufnahmevorrichtung.

Die flexible Leiterplatte erhält, wie in FIG 3 ersichtlich, an ihrem einen Ende ein Anschlußfeld 10, das mit Bohrungen 11 versehen ist, in die die Steckerstifte 2 des Steckers 1 eingreifen und dort verlötet werden. Am anderen Ende der flexiblen Leiterplatte 4 befindet sich der Bügel 7, der im Bereich der Lötanschlüsse 14 eine Aussparung aufweist, sowie zwei Laschen 13 in denen sich die Bohrungen 11 für die Befestigung des Bügels 7 auf der starren Leiterplatte befinden.

In FIG 4 ist der Schnitt III-III durch die flexible Leiterplatte FIG 3 dargestellt, wobei auf der flexiblen Leiterplatte 4 die starre Anschlußplatte 10 und der starre Bügel 7 für die Zugentlastung am gegenüberliegenden Ende erkennbar ist.

## Patentansprüche

1. Vorrichtung zur Zugentlastung für auf Leiterbahnanschlüsse von starren Leiterplatten (6) unmittelbar aufgelötete flexible Leiterplatten (4),
**dadurch gekennzeichnet,** daß an der für den Anschluß an die starre Leiterplatte (6) vorgesehenen Seite der flexiblen Leiterplatte (4) ein Bügel (7) aus starrem Material, wie z.B. faserverstärktem Epoxydharz, auflaminiert ist, der im Bereich der Lötstellen (5) ausgespart und außerdem mit Laschen (13) versehen ist, in denen sich Bohrungen (12) für Befestigungselemente (8) befinden.

## Claims

1. Device for strain relief for flexible printed-circuit boards (4) which are soldered directly onto conductor track connections of rigid printed-circuit boards (6), characterised in that a bracket (7) composed of rigid material, for example fibre-reinforced epoxy resin, is laminated onto the side of the flexible printed-circuit board (4) provided for connection to the rigid printed-circuit board (6), which bracket (7) is recessed in the region of the solder points (5) and is additionally provided with lugs (13) in which holes (12) for attachment elements (8) are provided.

## Revendications

1. Dispositif de relachement de la traction pour des plaquettes souples à circuits imprimés (4), fixées par brasage directement sur des bornes de voies conductrices de plaquettes rigides à circuits imprimés (6),
caractérisé par le fait que sur le côté de la plaque souple à circuits imprimés (4), prévu pour le raccordement à la plaquette rigide à circuits imprimés (6), est appliqué un étrier (7) en un matériau rigide, comme par exemple en une résine époxyde renforcée par des fibres, qui est évidé dans la zone des points de brasage (5) et qui, en outre, est pourvue de pattes (13) dans lesquelles sont ménagés des perçages (12) pour des éléments de fixation (8).
